# EUROPEAN PATENT APPLICATION

(11) **EP 4 576 136 A1**
(43) Date of publication of application: **25.06.2025**
(21) Application number: 24216141.2
(22) Date of filing: 28.11.2024
(51) Int. Cl.: H01G 2/06, H01G 4/232, H01G 4/30, H01G 4/12

(54) **MULTILAYER ELECTRONIC COMPONENT**

(30) Priority: 22.12.2023 KR 20230189549
(71) Applicant: Samsung Electro-Mechanics Co., Ltd., Gyeonggi-do (KR)
(72) Inventor: Woo, Min Sik, Suwon-si, Gyeonggi-do (KR); Lee, Da Jeong, Suwon-si, Gyeonggi-do (KR); Jhun, Jeong Pil, Suwon-si, Gyeonggi-do (KR)
(74) Representative: Grünecker Patent- und Rechtsanwälte PartG mbB

(57) **Abstract**

A multilayer electronic component includes a body including a dielectric layer and internal electrodes alternately disposed with the dielectric layer, and including first and second surfaces opposing each other in a first direction, third and fourth surfaces opposing each other in a second direction, fifth and sixth surfaces opposing each other in a third direction; and external electrodes including central portions disposed on centers of the third and fourth surfaces and outer portions disposed on outer regions of the third and fourth surfaces. The external electrode includes a lower electrode layer disposed in the central and outer portions, and an upper electrode layer disposed in the outer portion and disposed on the lower electrode layer. When a maximum size in the second direction of the central portion is defined as Le1, a maximum size in the second direction of the outer portion is defined as Le2, Le2>Le1 is satisfied.

## Description

### CROSS-REFERENCE TO RELATED APPLICATION(S)

The present application claims the benefit of priority to Korean Patent Application No. 10-2023-0189549, filed on December 22, 2023 in the Korean Intellectual Property Office, the entire disclosure of which is incorporated herein by reference.

### TECHNICAL FIELD

The present disclosure relates to a multilayer electronic component.

### BACKGROUND

A multilayer ceramic component (MLCC), a multilayer electronic component, may be a chip condenser mounted on the printed circuit boards of various electronic products including image display devices such as a liquid crystal display (LCD) and a plasma display panel (PDP), a computer, a smartphone, a mobile phone, or the like, and charging or discharging electricity therein or therefrom. Such a multilayer ceramic capacitor may be used as a component of various electronic devices, since a multilayer ceramic capacitor may have a small size and high capacitance and may be easily mounted.

Recently, as a multilayer electronic component has been designed to have a smaller size, defects such as misalignment of a mounting position of the multilayer electronic component depending on a solder coating state, a pad size of a printed circuit board may occur, and it has been difficult to stably mount a multilayer electronic component on the printed circuit board. Accordingly, research on a multilayer electronic component having excellent mounting stability has been necessary.

### SUMMARY

An embodiment of the present disclosure is to provide a multilayer electronic component having excellent mounting stability.

According to an embodiment of the present disclosure, a multilayer electronic component includes a body including a dielectric layer and internal electrodes alternately disposed with the dielectric layer, and including a first surface and a second surface opposing each other in a first direction, a third surface and a fourth surface connected to the first and second surfaces and opposing each other in a second direction, and a fifth surface and a sixth surface connected to the first to fourth surfaces and opposing each other in a third direction; and external electrodes including central portions disposed in centers of the third and fourth surfaces and outer portions connected to the central portions and disposed in outer regions of the third and fourth surfaces, wherein the external electrode includes a lower electrode layer disposed on the central portion and the outer portion and in contact with the internal electrode, and an upper electrode layer disposed on the outer portion and disposed on the lower electrode layer, and wherein, when a maximum size in the second direction of the central portion is defined as Le1 and a maximum size in the second direction of the outer portion is defined as Le2, Le2>Le1 is satisfied.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a perspective diagram illustrating a multilayer electronic component according to an embodiment of the present disclosure;
FIG. 2 is an exploded perspective diagram illustrating a body in FIG. 1 according to an embodiment of the present disclosure;
FIG. 3 is a cross-sectional diagram taken along line I-I' in FIG. 1;
FIG. 4 is a cross-sectional diagram taken along line II-II' in FIG. 1;
FIG. 5 is a diagram taken in direction A in FIG. 3, viewed from side;
FIGS. 6 and 7 are diagrams modified examples in FIG. 5;
FIG. 8 is a cross-sectional diagram illustrating a state in which a multilayer electronic component is mounted on a printed circuit board according to an embodiment of the present disclosure;
FIG. 9 is a plan diagram illustrating a state in which a pattern for an upper electrode layer for forming an upper electrode layer of a multilayer electronic component is printed on a surface plate according to an embodiment of the present disclosure; and
FIG. 10 is a diagram illustrating a process of forming an upper electrode layer of a multilayer electronic component according to an embodiment of the present disclosure.

### DETAILED DESCRIPTION

Hereinafter, embodiments of the present disclosure will be described as below with reference to the accompanying drawings.

These embodiments are described in sufficient detail to enable those skilled in the art to practice the invention. It is to be understood that the various embodiments of the invention, although different, are not necessarily mutually exclusive. For example, structures, shapes, and sizes described as examples in embodiments in the present disclosure may be implemented in another embodiment without departing from the spirit and scope of the present disclosure. Further, modifications of positions or arrangements of elements in embodiments may be made without departing from the spirit and scope of the present disclosure. The following detailed description is, accordingly, not to be taken in a limiting sense, and the scope of the present disclosure are defined only by appended claims, appropriately interpreted, along with the full range of equivalents to which the claims are entitled.

In the drawings, same elements will be indicated by same reference numerals. Also, redundant descriptions and detailed descriptions of known functions and elements which may unnecessarily make the gist of the present disclosure obscure will be omitted. In the accompanying drawings, some elements may be exaggerated, omitted or briefly illustrated, and the sizes of the elements do not necessarily reflect the actual sizes of these elements. The terms, "include," "comprise," "is configured to," or the like of the description are used to indicate the presence of features, numbers, steps, operations, elements, portions or combination thereof, and do not exclude the possibilities of combination or addition of one or more features, numbers, steps, operations, elements, portions or combination thereof.

In the drawings, the first direction may be defined as a thickness (T) direction, the second direction may be defined as a length (L) direction, and the third direction may be defined as a width (W) direction.

In one or more aspects, the terms "substantially," "about," and "approximately" may provide an industry-accepted tolerance for their corresponding terms and/or relativity between items, such as a tolerance of ± 1%, ± 5% , or ± 10% of the actual value stated, and other suitable tolerances.

### Multilayer Electronic Component

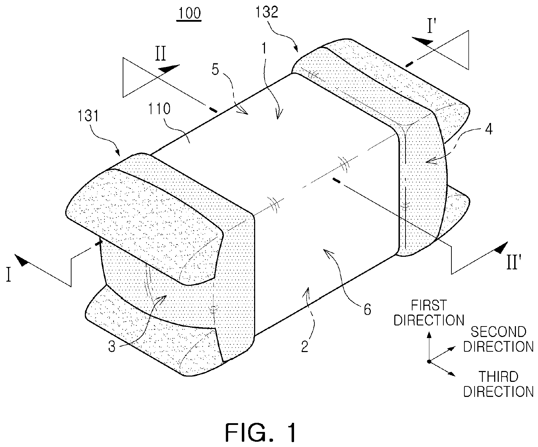

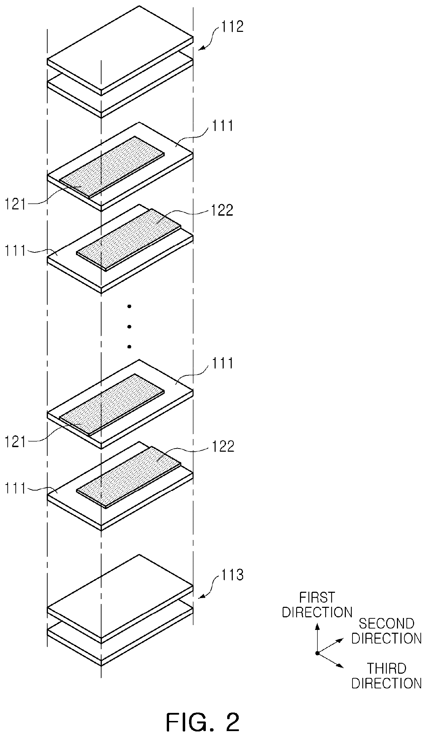

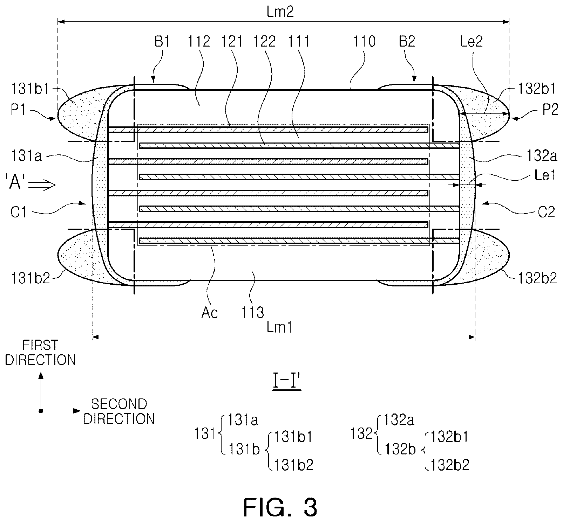

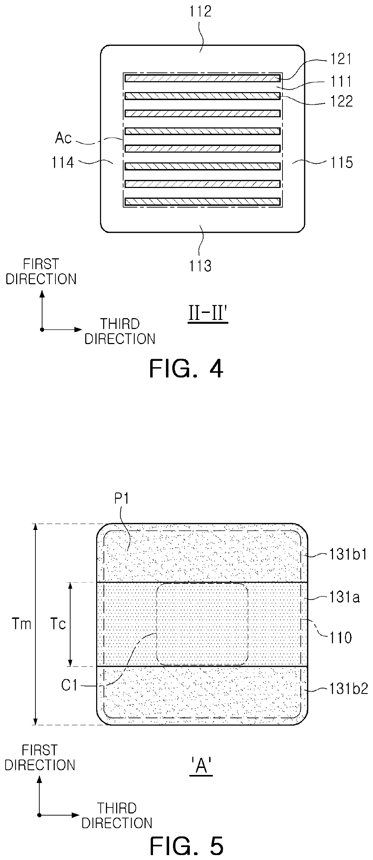

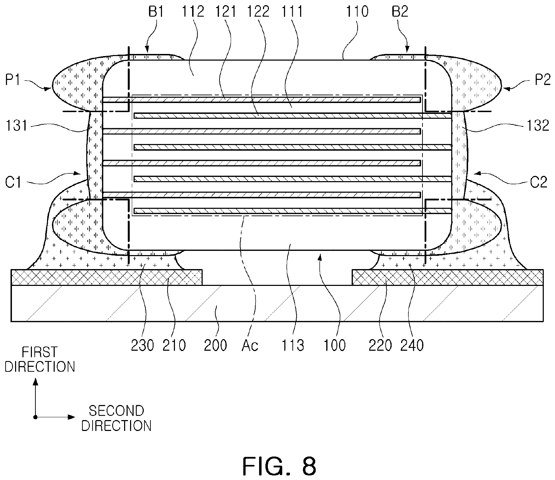

FIG. 1 is a perspective diagram illustrating a multilayer electronic component according to an embodiment. FIG. 2 is an exploded perspective diagram illustrating a body in FIG. 1 according to an embodiment. FIG. 3 is a cross-sectional diagram taken along line I-I' in FIG. 1. FIG. 4 FIG. 5 is a diagram taken in direction A in FIG. 3, viewed from side. is a cross-sectional diagram taken along line II-II' in FIG. 1. FIG. 8 is a cross-sectional diagram illustrating a state in which a multilayer electronic component is mounted on a printed circuit board according to an embodiment.

Hereinafter, a multilayer electronic component according to an embodiment will be described in greater detail with reference to FIGS. 1 to 5 and 8. A multilayer ceramic capacitor will be described as an example of a multilayer electronic component, but an embodiment thereof is not limited thereto, and the multilayer ceramic capacitor may be applied to various multilayer electronic components, such as an inductor, a piezoelectric element, a varistor, or a thermistor.

Referring to FIGS. 1 to 3, the multilayer electronic component 100 according to an embodiment may include a body 110 including a dielectric layer 111 and internal electrodes 121 and 122, and external electrodes 131 and 132.

The shape of the body 110 may not be limited to any particular shape, but as illustrated, the body 110 may have a hexahedral shape or a shape similar to a hexahedral shape. Due to shrinkage of ceramic powder included in the body 110 during a sintering process or polishing of corners, the body 110 may not have an exactly hexahedral shape formed by linear lines but may have a substantially hexahedral shape.

The body 110 may have first and second surfaces 1 and 2 opposing each other in the first direction, third and fourth surfaces 3 and 4 connected to the first and second surfaces 1 and 2 and opposing in the second direction, and fifth and sixth surfaces 5 and 6 connected to the first and second surfaces 1 and 2 and the third and fourth surfaces 3 and 4 and opposing each other in the third direction.

The body 110 may include the dielectric layer 111 and the first and second internal electrodes 121 and 122 disposed alternately in the first direction with the dielectric layer 111 interposed therebetween. The plurality of dielectric layers 111 forming the body 110 may be in a sintered state, and boundaries between adjacent dielectric layers 111 may be integrated with each other such that boundaries therebetween may not be distinct without using a scanning electron microscope (SEM).

The average thickness of the dielectric layer 111 is not limited to any particular example. The average thickness of the dielectric layer 111 may be, for example, 0.1 um to 10 um, 0.1 um to 5 um, 0.1 um to 2 um, or 0.1 um to 0.4 µm.

The dielectric layer 111 may be formed by preparing a ceramic slurry including ceramic powder, an organic solvent, an additive, and a binder, preparing a ceramic green sheet by coating the slurry on a carrier film and drying the slurry, and sintering the ceramic green sheet. The ceramic powder is not limited to any particular example as long as sufficient electrostatic capacitance may be obtained therewith. For example, a barium titanate material, lead composite perovskite material, or strontium titanate materials may be used. An example of the ceramic powder may include BaTiO₃, (Ba₁₋ₓCaₓ)TiO₃ (0<x<1), Ba(Ti_{x-y}Ca_{y})O₃ (0<y<1), (Ba₁₋ₓCaₓ)(Ti_{1-y}Zr_{y})O₃ (0<x<1, 0<y<1) or Ba(Ti_{1-y}Zr_{y})O₃ (0<y<1) in which Ca (calcium) and Zr (zirconium) are partially dissolved. The organic solvent may be ethanol, the binder may be polyvinyl butyral, and the organic solvent and binder may be a generally used material used in the art.

The internal electrodes 121 and 122 may include, for example, a first internal electrodes 121 and a second internal electrode 122 disposed alternately with the dielectric layer 111 interposed therebetween. That is, the first internal electrodes 121 and the second internal electrode 122, a pair of electrodes having different polarities, may be disposed to oppose each other with the dielectric layer 111 interposed therebetween. The first internal electrodes 121 and the second internal electrode 122 may be electrically separated from each other by the dielectric layer 111 interposed therebetween.

The first internal electrode 121 may be spaced apart from the fourth surface 4 and may be connected to the first external electrode 131 on the third surface 3. The second internal electrode 122 may be spaced apart from the third surface 3 and may be connected to the second external electrode 132 on the fourth surface 4.

The conductive metal included in the internal electrodes 121 and 122 may be one or more of Ni, Cu, Pd, Ag, Au, Pt, Sn, W, Ti and alloys thereof, and may include Ni more preferably, but an embodiment thereof is not limited thereto.

The average thickness of the internal electrodes 121 and 122 may not be limited to any particular example. The average thickness of the internal electrodes 121 and 122 may be, for example, 0.1 um to 5.0 um, 0.1 um to 3.0 um, 0.1 um to 1.0 um, or 0.1 um to 0.4 µm.

The internal electrodes 121 and 122 may be formed by applying a conductive paste for an internal electrode including a conductive metal to a predetermined thickness on the ceramic green sheet and firing. As a printing method for the conductive paste for internal electrodes, a screen-printing method or a gravure printing method may be used, but an embodiment thereof is not limited thereto.

An average thickness of the dielectric layer 111 and an average thickness of the internal electrodes 121 and 122 may indicate sizes of the dielectric layer 111 and the internal electrodes 121 and 122 in the first direction, respectively. The average thickness of the dielectric layer 111 and the average thickness of the internal electrodes 121 and 122 may be measured by scanning a cross-section in the first and second directions of the body 110 using a scanning electron microscope (SEM) with a magnification of 10,000. More specifically, the average thickness of the dielectric layer 111 may be measured from the thicknesses of the dielectric layer 111 at 30 points at an equal distance in the second direction. Also, the average thickness of internal electrodes 121 and 122 may be measured by measuring the thickness at multiple points of one internal electrode 121 and 122, for example, 30 points at an equal distance in the second direction. The 30 points at an equal distance may be designated in the capacitance formation portion Ac. By measuring the average value after performing the average value measurements on ten dielectric layers 111 and 10 internal electrodes 121 and 122, respectively, the average thickness of the dielectric layer 111 and the average thickness of the internal electrodes 121 and 122 may be further generalized.

The body 110 may include a capacitance formation portion Ac disposed in the body 110 and including the first and second internal electrodes 121 and 122 disposed alternately with the dielectric layer 111 interposed therebetween, and a first cover portion 112 and a second cover portion 113 disposed on both surfaces of the capacitance formation portion Ac opposing each other in the first direction. The cover portions 112 and 113 may prevent damages to the internal electrode due to physical or chemical stress. The cover portions 112 and 113 may be configured similarly to the dielectric layer 111, other than the configuration in which the cover portions 112 and 113 do not include an internal electrode.

An average thickness of the cover portions 112 and 113 may not be limited to any particular example. The average thickness of the cover portions 112 and 113 may be, for example, 300 um or less, 100 um or less, 50 um or less, or 20 um or less, but an embodiment thereof is not limited thereto. Here, the average thickness of the cover portions 112 and 113 may indicate the average thickness of each of the first cover portion 112 and the second cover portion 113.

The average thickness of the cover portions 112 and 113 may indicate the average size in the first direction of the cover portions 112 and 113, and may be an average value of the first direction size measured at five points at an equal distance in the second direction in a cross-section in the first direction and second direction passing through a center of the body 110 in the third direction.

The body 110 may include first and second margin portions 114 and 115 disposed on both surfaces opposing each other in the third direction of the capacitance formation portion Ac. The margin portions 114 and 115 may refer to a region between both ends of the internal electrodes 121 and 122 and the boundary surface of the body 110 in a cross-section in the first and third directions of the body 110.

The margin portions 114 and 115 may be configured similarly to the dielectric layer 111 other than the configuration in which the internal electrodes 121 and 122 are not included. The margin portions 114 and 115 may basically prevent damage to the internal electrodes 121 and 122 due to physical or chemical stress.

The average thickness of the margin portions 114 and 115 may not be limited to any particular example. The average thickness of the margin portions 114 and 115 may be 200 um or less, 100 um or less, 20 um or less, or 15 um or less, but an embodiment thereof is not limited thereto. Here, the average thickness of the margin portions 114 and 115 may indicate the average thickness of the first margin portion 114 and the second margin portion 115, respectively.

The average thickness of the margin portions 114 and 115 may refer to an average size in the third direction of the margin portions 114 and 115, and may be an average value of sizes in the third direction, measured at five points at an equal distance in the first direction in a cross-section in the first and third directions of the body 110.

The margin portions 114 and 115 may be formed by applying and sintering a conductive paste for an internal electrode other than a position in which the margin portion is formed on the ceramic green sheet. Alternatively, to suppress a step difference formed by the internal electrodes 121 and 122, the internal electrodes 121 and 122 may be cut to be exposed to the fifth and sixth surfaces 5 and 6 of the body, and a single dielectric layer or two or more dielectric layers may be laminated on both surfaces in the third direction of the capacitance formation portion Ac opposing each other, thereby forming the margin portions 114 and 115.

The external electrodes 131 and 132 may be disposed on the third and fourth surfaces 3 and 4 of the body 110, and may extend to a portion of the first surface, second, fifth and sixth surfaces 1, 2, 5, and 6. The external electrodes 131 and 132 may include a first external electrode 131 connected to the first internal electrodes 121 and a second external electrode 132 connected to the second internal electrode 122. In the drawing, the multilayer electronic component 100 may have two external electrodes 131 and 132, but an embodiment thereof is not limited thereto, and the number or the shape of the external electrodes 131 and 132 may be varied depending on the shape of the internal electrodes 121, 122 or other purposes.

The external electrodes 131 and 132 may include central portion C1 and C2 disposed on centers of third and fourth surfaces 3 and 4, and outer portion P1 and P2 connected to the central portion C1 and C2 and disposed on an outer region of third and fourth surfaces 3 and 4. The external electrodes 131 and 132 may include band portions B1 and B2 extending from the outer portions P1 and P2 to a portions of the first and second surfaces 1 and 2. The band portions B1 and B2 may also extend from the outer portions P1 and P2 to a portion of the fifth and sixth surfaces 5 and 6.

The first external electrode 131 may include a first central portion C1 disposed on a center of the third surface 3, a first outer portion P1 disposed on an outer region of the third surface 3 and connected to the first central portion C1, and a first band portion B1 extending from the first outer portion P1 to a portion of the first and second surfaces 1, 2. The second external electrode 132 may include a second central portion C2 disposed on the center of the fourth surface 4, a second outer portion P2 disposed on the outer region of the fourth surface 4 and connected to the second central portion C2, and a second band portion B2 extending from the second outer portion P2 to a portion of the first and second surfaces 1, 2.

According to an embodiment, the external electrodes 131 and 132 may include lower electrode layers 131a and 132a disposed in the central portion C1 and C2 and the outer portion P1 and P2 and in contact with the internal electrodes 121 and 122, and upper electrode layers 131b and 132b disposed in the outer portion P1 and P2 and disposed on the lower electrode layers 131a and 132a, respectively. For example, the upper electrode layers 131b and 132b may not be disposed in the central portion C1 and C2.

The first external electrode 131 may include a first lower electrode layer 131a disposed in the first central portion C1 and the first outer portion P1 and in contact with the first internal electrode 121, and a first upper electrode layer 131b disposed in the first outer portion P1 and disposed on the first lower electrode layer 131a. The first upper electrode layer 131b may not be disposed in the first central portion C1.

The second external electrode 132 may include a second lower electrode layer 132a disposed in the second central portion C2 and the second outer portion P2 and in contact with the second internal electrode 122, and a second upper electrode layer 132b disposed in the second outer portion P2 and disposed on the second lower electrode layer 132a. The second upper electrode layer 132b may not be disposed in the second central portion C2.

The boundary between the central portions C1 and C2 and the outer portions P1 and P2 may correspond to, for example, ends of the upper electrode layers 131b and 132b adjacent to the central portions C1 and C2. The boundary between the outer portions P1 and P2 and the band portions B1 and B2 may correspond to ends of the upper electrode layers 131b and 132b adjacent to the band portions B1 and B2. For example, referring to FIG. 3, in a cross-section in the first direction and second direction of the multilayer electronic component 100, the boundary between the central portions C1 and C2 and the outer portions P1 and P2 may correspond to one end in the first direction of the upper electrode layers 131b and 132b adjacent to the central portions C1 and C2, and the boundary between the outer portions P1 and P2 and the band portions B1 and B2 may correspond to the other end in the first direction of the upper electrode layers 131b and 132b adjacent to the band portions B1 and B2.

According to an embodiment, the maximum size Le2 in the second direction of the outer portion may be greater than the maximum size Le1 in the second direction of the central portion. That is, Le2>Le1 may be satisfied. The maximum size in the second direction of the first outer portion P1 may be greater than the maximum size in the second direction of the first central portion C1, and the maximum size in the second direction of the second outer portion P2 may be greater than the maximum size in the second direction of the second central portion C2.

In the case of the multilayer electronic component 100 according to an embodiment, by including the upper electrode layers 131b and 132b disposed in the outer portions P1 and P2, Le2>Le1 may be satisfied, and accordingly, by increasing the size in the second direction of the outer portion P1 and P2, which may be regions in contact with pads or solder of the printed circuit board, mounting stability of the multilayer electronic component 100 may improve.

Referring to FIG. 8, a printed circuit board 200 on which a multilayer electronic component 100 is mounted may include a plurality of pads 210 and 220 disposed on one surface. The solder 230 and 240 may connect the plurality of pads 210 and 220 to the multilayer electronic component 100. Basically, the multilayer electronic component 100 may be mounted on the printed circuit board 200 through band portions B1 and B2 of the external electrodes 131 and 132 in contact with the solder 230 and 240.

In the case of the multilayer electronic component 100 according to an embodiment, since the maximum size Le2 in the second direction of the outer portions P1 and P2 is greater than the maximum size Le1 in the second direction of the central portions C1 and C2, the solder 230 and 240 may be in contact with the band portions B1 and B2 and also the outer portions P1 and P2. Accordingly, by increasing a contact area between the multilayer electronic component 100 and the solder 230 and 240, mounting stability of the multilayer electronic component 100 may improve.

Also, depending on the size or shape of the outer portions P1 and P2, the solder 230 and 240 may flow upwardly along the outer portions P1 and P2, and the solder 230 and 240 may be in contact with the surface adjacent to the central portion C1 and C2 among outer surfaces of the outer portions P1 and P2, or may be in contact with the central portion C1 and C2. In this case, the solder 230 and 240 may generate a force pressing the outer portions P1 and P2 in the direction in which the printed circuit board 200 is disposed. Accordingly, the effect of improving mounting stability of the multilayer electronic component 100 may be more prominent.

When Le2>Le1 is satisfied, the shape of the outer portions P1 and P2 may not be limited to any particular example. However, in an embodiment, at least a portion of the outer portions P1 and P2 may have a shape convexly protruding more outwardly than the central portions C1 and C2.

Referring to FIG. 3, in an embodiment, when the maximum size in the second direction of the multilayer electronic component 100 measured at the central portion C1 and C2 is defined as Lm1, and the maximum size in the second direction of the multilayer electronic component 100 measured at the outer portion P1 and P2 is defined as Lm2, 0.01≤(Lm2-Lm1)/Lm1≤0.05 may be satisfied. When (Lm2-Lm1)/Lm1 is less than 0.01, the effect of improving mounting stability of the embodiment may be insignificant. When (Lm2-Lm1)/Lm1 exceeds 0.05, capacitance per unit volume of the multilayer electronic component 100 may be reduced.

Referring to FIG. 5, in an embodiment, when the maximum size in the first direction of the multilayer electronic component is defined as Tm, and the size of the first direction of the central portion is defined as Tc, a ratio of to (Tc/Tm) may be greater than 0. More preferably, the ratio of to (Tc/Tm) may be 0.5 or greater. When Tc/Tm is less than 0.5, it may be difficult for solder to flow upwardly along the outer portion and to be contact with the central portion. An upper limit of Tc/Tm may not be specifically limited and may be less than 1.

The lower electrode layers 131a and 132a may extend from the outer portions P1 and P2 to the band portions B1 and B2. In an embodiment, ends of the lower electrode layers 131a and 132a may be disposed in the band portions B1 and B2. For example, the first lower electrode layer 131a may extend from the first outer portion P1 to the first band portion B1 such that the end of the first lower electrode layer 131a may be disposed in the first band portion B1. The second lower electrode layer 132a may extend from the second outer portion P2 to the second band portion B2 such that the end of the second lower electrode layer 132a may be disposed in the second band portion B2.

In an embodiment, the lower electrode layers 131a and 132a may have a maximum thickness in the central portions C1 and C2 and a minimum thickness in the outer portions P1 and P2. The lower electrode layers 131a and 132a may have a maximum thickness in the center of the first direction of the central portions C1 and C2, for example. The lower electrode layers 131a and 132a may have a minimum thickness in a corner of the round shape of the body 110, for example. Each of the central portions C1 and C2 of the external electrodes 131 and 132 may be convex outwardly by the lower electrode layers 131a and 132a.

The lower electrode layers 131a and 132a may be formed by, for example, dipping the third and fourth surfaces 3 and 4 of the body 110 into a conductive paste including metal powder, glass, a binder, and an organic solvent, and sintering. That is, the lower electrode layers 131a and 132a may be sintered electrodes including, for example, metal and glass. The metal included in the lower electrode layers 131a and 132a may include one or more of Cu, Ni, Pd, Pt, Au, Ag, Pb, and alloys thereof, but an embodiment thereof is not limited thereto.

When Le2>Le1 is satisfied, the type of the upper electrode layers 131b and 132b may not be limited to any particular example. In an embodiment, the upper electrode layers 131b and 132b may include metal and glass. That is, the upper electrode layers 131b and 132b may be sintered electrodes including metal and glass. When the upper electrode layers 131b and 132b are sintered electrodes, the metal included in the upper electrode layers 131b and 132b may include one or more of Cu, Ni, Pd, Pt, Au, Ag, Pb, and alloys thereof, but an embodiment thereof is not limited thereto.

In an embodiment, the upper electrode layers 131b and 132b may include metal and resin. That is, the upper electrode layers 131b and 132b may be resin electrodes including metal and resin. When the upper electrode layers 131b and 132b are resin electrodes, the metal included in the upper electrode layers 131b and 132b may include one or more of Cu, Ni, Ag, Pd, Sn and alloys thereof, but an embodiment thereof is not limited thereto. The resin included in the upper electrode layers 131b and 132b may be an epoxy resin and/or an acrylic resin, but an embodiment thereof is not limited thereto.

When Le2>Le1 is satisfied, the shape of the upper electrode layers 131b and 132b may not be limited to any particular example. In an embodiment, the upper electrode layers 131b and 132b may not cover ends of the lower electrode layers 131a and 132a disposed in the band portions B1 and B2. To improve mounting stability of the multilayer electronic component 100 and to prevent capacitance per unit volume from decreasing due to an increase in the maximum size in the first direction of the multilayer electronic component 100, the upper electrode layers 131b and 132b may not be disposed in, for example, the band portions B1 and B2. Even when a portion of the upper electrode layers 131b and 132b extends from the outer portions P1 and P2 to the band portions B1 and B2, it may be desirable for the upper electrode layers 131b and 132b not to cover the ends of the lower electrode layers 131a and 132a.

Referring to FIGS. 3 and 5, in an embodiment, the upper electrode layers 131b and 132b may include first electrode layers 131b1 and 132b1 disposed on one ends in the first direction of the third and fourth surfaces 3 and 4, and second electrode layers 131b2 and 132b2 disposed on the other ends in the first direction of the third and fourth surfaces 3 and 4. For example, the first upper electrode layer 131b may include a 1-1-th electrode layer 131b1 disposed on one end in the first direction of the third surface 3 and a 2-1-th electrode layer 131b1 disposed on the other end in the first direction of the third surface 3, and the second upper electrode layer 132b may include a 1-2-th electrode layer 132b1 disposed on one end in the first direction of the fourth surface 4 and a 2-2-th electrode layer 132b2 disposed on the other end in the first direction of the fourth surface 4.

The first electrode layer 131b1 and 132b1 and the second electrode layer 131b2 and 132b2 may be spaced apart from each other and may extend in the third direction. The 1-1-th electrode layer 131b1 and 2-1-th electrode layer 131b2 may be spaced apart from each other and may extend in the third direction, and the 1-2-th electrode layer 132b1 and 2-2-th electrode layer 132b2 may be spaced apart from each other and may extend in the third direction.

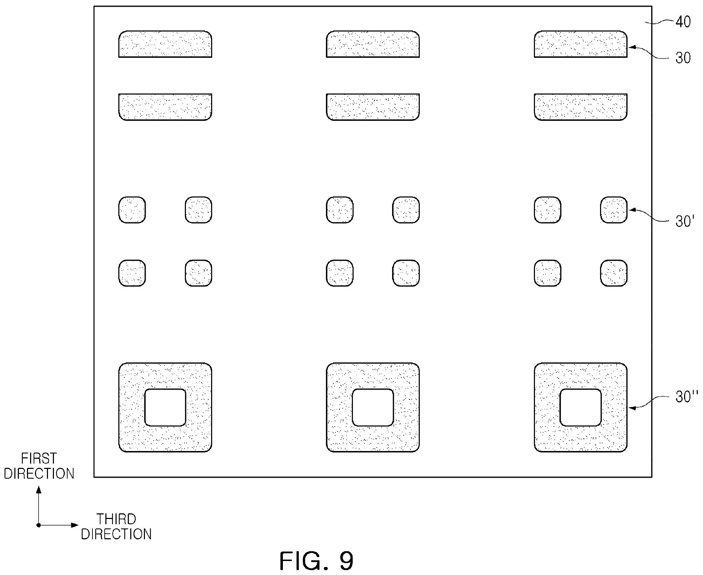

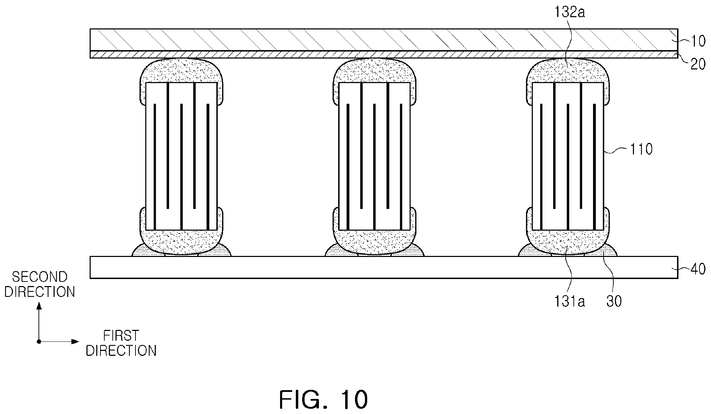

FIG. 9 is a plan diagram illustrating a state in which a pattern for an upper electrode layer for forming an upper electrode layer of a multilayer electronic component is printed on a surface plate according to an embodiment. FIG. 10 is a diagram illustrating a process of forming an upper electrode layer of a multilayer electronic component according to an embodiment.

An example of a method of forming the upper electrode layers 131b and 132b will be described with reference to FIGS. 9 and 10. Referring to FIG. 9, a plurality of patterns 30 for the upper electrode layers may be printed on the surface plate 40. The pattern 30 for the upper electrode layer may be formed by printing a conductive paste including metal powder, glass, a binder, and an organic solvent, for example, using a screen-printing method. Alternatively, the pattern 30 for the upper electrode layer may be formed by printing a conductive resin composition including metal powder, resin, a binder, and an organic solvent, for example, using a screen-printing method.

Referring to FIG. 10, the body 110 on which the lower electrode layers 131a and 132a are formed may be attached to the first stainless steel plate 10 using a UV tape 20. That is, the second lower electrode layer 132a may be bonded to the first stainless steel plate 10 through UV tape 20, Thereafter, the pattern 30 for the upper electrode layer may be bonded to the first lower electrode layer 131a by pressing a stainless steel plate 10 to the surface plate 40, and the pattern 30 for the upper electrode layer attached to the first lower electrode layer 131a may be dried.

Although not illustrated, the first lower electrode layer 131a having the pattern 30 for the upper electrode layer attached thereto, the opposite side of the second lower electrode layer 132a, may be bonded to the second stainless steel plate (not illustrated) through the UV tape, and the UV tape 20 attached to the second lower electrode layer 132a may be removed by a UV transfer machine. Thereafter, the pattern for the upper electrode layer may be attached to the second lower electrode layer 132a in the same manner and may be dried, and the UV tape attached to the first lower electrode layer 131a side may be removed by a UV transfer machine.

Thereafter, the upper electrode layer 131b and 132b may be formed by firing the pattern 30 for the upper electrode layer attached to the first and second lower electrode layers 131a and 132a at a temperature of 700°C to 900°C.

Although not illustrated, the external electrodes 131 and 132 may further include an external plating layer disposed on the lower electrode layer 131a and 132a and the upper electrode layer 131b and 132b. The external plating layer may be in contact with the lower electrode layer 131a and 132a at the central portion C1 and C2, may be in contact with the upper electrode layer 131b and 132b at the outer portion P1 and P2, and may be in contact with the lower electrode layer 131a and 132a at the band portion B1 and B2.

The type of the external plating layer is not limited to any particular example, and may be a plating layer including Ni, Sn, Pd, and/or an alloy including the same, and may be formed as a plurality of layers. The external plating layer may be, for example, a Ni plating layer or a Sn plating layer, and a Ni plating layer and a Sn plating layer may be formed in order in the external plating layer. Also, the external plating layer may include a plurality of Ni plating layers and/or a plurality of Sn plating layers.

The size of the multilayer electronic component 100 may not be limited to any particular example. However, as described above, as the size of the multilayer electronic component 100 decreases, a defect in which a mounting position of the multilayer electronic component 100 may be misaligned may significantly occur. Accordingly, when the multilayer electronic component 100 has a size of 0603 standard (maximum size in the second direction: 0.6mm±0.03mm, maximum size in the third direction:0.3mm±0.03mm) or lower, the effect of improving mounting stability according to an embodiment may be more prominent. Accordingly, in an embodiment, the maximum size in the second direction of the multilayer electronic component 100 may be 0.63mm or lower, and the maximum size in the third direction of the multilayer electronic component 100 may be 0.33mm or lower.

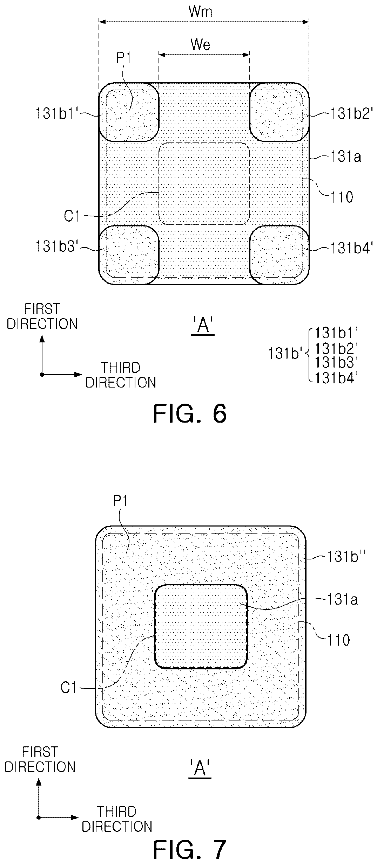

FIG. 6 is a diagram illustrating a modified example in FIG. 5, illustrating the first external electrode side viewed from side, but since the first external electrode and the second external electrode may be symmetrical in the second direction and the configurations thereof may be substantially the same, the description as below may include both the descriptions of the first external electrode and the second external electrode.

In an embodiment, the upper electrode layer may include first to fourth corner electrode layers disposed on corners of the third and fourth surfaces 3 and 4 and spaced apart from each other. The upper electrode layer may include first to fourth corner electrode layers disposed on corners of the outer portion and spaced apart from each other.

For example, referring to FIG. 6, the first upper electrode layer 131b' may include first to fourth corner electrode layers 131b1', 131b2', 131b3', and 131b4' disposed on the corners of the third surface and spaced apart from each other. The first upper electrode layer 131b' may include first to fourth corner electrode layers 131b1', 131b2', 131b3', and 131b4' disposed on the corner of the first outer portion P1 and spaced apart from each other.

Although not illustrated, the second upper electrode layer may include first to fourth corner electrode layers disposed on corners of the fourth surface and spaced apart from each other. The second upper electrode layer may include first to fourth corner electrode layers disposed on corners of the second outer portion and spaced apart from each other.

Referring to FIG. 6, in an embodiment, when the maximum size of the multilayer electronic component in the third direction is defined as Wm, and the minimum distance in the third direction between the first corner electrode layer 131b1' and the second corner electrode layer 131b2' or the minimum distance in the third direction between the third corner electrode layer 131b3' and the fourth corner electrode layer 131b4' is defined as We, the ratio of We to Wm (We/Wm) may be 0.8 or lower. When the We/Wm exceeds 0.8, the effect of improving mounting stability of an embodiment may be insignificant. The lower limit of the We/Wm may need not be specifically limited and may exceed 0.

The first upper electrode layer 131b' may be formed by attaching the pattern 30' for the upper electrode layer printed on the surface plate 40 illustrated in FIG. 9 to the lower electrode layer 131a, and drying and firing the layer.

FIG. 7 is a diagram illustrating a modified example in FIG. 5, illustrating the first external electrode side viewed from side, but since the first external electrode and the second external electrode are symmetrical in the second direction and configurations thereof may be substantially the same, the description as below may include both the descriptions of the first external electrode and the second external electrode.

In an embodiment, the upper electrode layer may be disposed to surround the central portion. For example, referring to FIG. 7, the first upper electrode layer 131b" may be disposed to surround the first central portion C1. The first upper electrode layer 131b" may be disposed to cover the outer portion P1.

The first upper electrode layer 131b" may be formed by attaching the pattern 30" for the upper electrode layer printed on the surface plate 40 illustrated in FIG. 9 to the lower electrode layer 131a, and drying and firing the layer.

### (Experimental example)

BaTiO₃ powder, organic solvent such as ethanol, and binder such as polyvinyl butyral were mixed to prepare ceramic slurry, and the ceramic slurry was applied on a carrier film and dried, thereby preparing a ceramic green sheet. Thereafter, conductive paste for an internal electrode including Ni powder, an organic solvent, and a binder was applied on the ceramic green sheet to a predetermined thickness and an internal electrode pattern is formed.

Thereafter, the ceramic green sheet on which the internal electrode pattern was formed was laminated in tens to hundreds of layers, pressed and cut, a firing process was performed at a temperature of 1100°C or higher to 1200°C or lower, and a body was formed.

Thereafter, the third and fourth surfaces of the body were dipped in a conductive paste for a lower electrode layer including Cu powder, glass, a binder, and an organic solvent, fired at a temperature of 700°C to 900°C and a lower electrode layer was formed.

Thereafter, the body on which the lower electrode layer was formed was attached to a stainless steel plate using UV tape, and the stainless steel plate was pressed against the surface plate on which the pattern for the upper electrode layer was printed. The pattern for the upper electrode layer was formed by printing a conductive paste including Cu powder, glass, binder, and organic solvent on the surface plate. Thereafter, the pattern for the upper electrode layer attached to the lower electrode layer was dried, formed at a temperature of 700°C to 900°C, and the upper electrode layer was formed.

Thereafter, a Ni plating layer and a Sn plating layer were formed on the lower electrode layer and the upper electrode layer and a sample chip was formed. The size of the sample chip was manufactured to the 0603 standard (size in the second direction: approximately 0.6 mm, and size in the third direction: approximately 0.3 mm).

Thereafter, 100 sample chips for each sample No. were mounted on a printed circuit board. In this case, the sample chip was mounted on a pad of the printed circuit board using solder, and the solder was artificially applied by shifting 0.2 mm from the pad of the printed circuit board in the second direction, thereby determining a mounting defect of the sample chip.

The sample chips of sample Nos. 2 to 5 below were manufactured using the same method, and only the difference between the maximum size in the second direction Lm1 of the sample chip measured at the central portion and the maximum size in the second direction Lm2 of the sample chip measured at the outer portion was different. In sample No. 1, the maximum size in the second direction Lm1 of the sample chip measured at the central portion and the maximum size in the second direction Lm2 of the sample chip measured at the outer portion were the same.

**[Table 1]**

| Classification | (Lm2-Lm1)/Lm1 | Mounting defect (%) |
|---|---|---|
| Sample No. 1 | 0 | 19 |
| Sample No. 2 | 0.005 | 18 |
| Sample No. 3 | 0.01 | 13 |
| Sample No. 4 | 0.015 | 9 |
| Sample No. 5 | 0.02 | 5 |

Referring to Table 1, sample Nos. 2 to 5 may have better mounting stability than sample No. 1, which may be because a contact area between the sample chip and the solder increased as Lm2 increased compared to Lm1. In particular, when (Lm2-Lm1)/Lm1 is 0.01 or higher, the mounting defect decreased rapidly.

The sample chips of sample Nos. 7 to 11 below were manufactured using the same method, and the upper electrode layer had the form illustrated in FIG. 6. Sample Nos. 7 to 11 had different ratios of the minimum distance We in the third direction between the first corner electrode layer and the second corner electrode layer to the maximum size in the third direction Wm of the sample chip (We/Wm).

The upper electrode layer of sample No. 6 had the form illustrated in FIG. 5, differently from sample Nos. 7 to 11. Accordingly, the We was indicated as 0. Sample No. 12, differently from sample Nos. 6 to 11, the process of forming the upper electrode layer on the outer portion was not performed. Accordingly, the We is denoted as 1.

**[Table 2]**

| Classification | We/Wm | Mounting defect (%) |
|---|---|---|
| Sample No. 6 | 0 | 5 |
| Sample No. 7 | 0.2 | 5 |
| Sample No. 8 | 0.4 | 6 |
| Sample No. 9 | 0.6 | 8 |
| Sample No. 10 | 0.8 | 9 |
| Sample No. 11 | 0.9 | 16 |
| Sample No. 12 | 1 | 19 |

Referring to Table 2, sample Nos. 6 to 11 had better mounting stability compared to sample No. 12, which may be because the external electrode included the upper electrode layer, such that the maximum size Le2 in the second direction of the outer portion increased further than the maximum size Le1 in the second direction of the central portion, and accordingly, the contact area between the sample chip and the solder increased. In particular, referring to sample Nos. 7 to 11, when the We/Wm is 0.8 or lower, the mounting defect was drastically reduced.

According to the aforementioned embodiments, a multilayer electronic component having excellent mounting stability may be provided.

The embodiments do not necessarily limit the scope of the embodiments to a specific embodiment form. Instead, modifications, equivalents and replacements included in the disclosed concept and technical scope of this description may be employed. Throughout the specification, similar reference numerals are used for similar elements.

In the embodiments, the term "embodiment" may not refer to one same embodiment, and may be provided to describe and emphasize different unique features of each embodiment. The suggested embodiments may be implemented do not exclude the possibilities of combination with features of other embodiments. For example, even though the features described in an embodiment are not described in the other embodiment, the description may be understood as relevant to the other embodiment unless otherwise indicated.

The terms "first," "second," and the like may be used to distinguish one element from the other, and may not limit a sequence and/or an importance, or others, in relation to the elements. In some cases, a first element may be referred to as a second element, and similarly, a second element may be referred to as a first element without departing from the scope of right of the example embodiments.

While the embodiments have been illustrated and described above, it will be configured as apparent to those skilled in the art that modifications and variations could be made without departing from the scope of the present disclosure as defined by the appended claims.

## Claims

1. A multilayer electronic component, comprising:
a body including a dielectric layer and internal electrodes alternately disposed with the dielectric layer, and including a first surface and a second surface opposing each other in a first direction, a third surface and a fourth surface connected to the first and second surfaces and opposing each other in a second direction, and a fifth surface and a sixth surface connected to the first to fourth surfaces and opposing each other in a third direction; and
external electrodes including central portions disposed on centers of the third and fourth surfaces, respectively, and outer portions connected to the central portions and disposed on outer regions of the third and fourth surfaces, respectively,
wherein each of the external electrodes includes a lower electrode layer disposed in the central portion and the outer portion and in contact with one of the internal electrodes, and an upper electrode layer disposed in the outer portion and disposed on the lower electrode layer, and
wherein, when a maximum size in the second direction of the central portion is defined as Le1 and a maximum size in the second direction of the outer portion is defined as Le2, Le2>Le1 is satisfied.

2. The multilayer electronic component of claim 1, wherein a boundary between the central portion and the outer portion corresponds to an end of the upper electrode layer adjacent to the central portion.

3. The multilayer electronic component of claim 1,
wherein each of the external electrodes includes a band portion extending from the outer portion to a portion of the first and second surfaces, and
wherein an end of the lower electrode layer is disposed in the band portion.

4. The multilayer electronic component of claim 3, wherein the upper electrode layer does not cover the end of the lower electrode layer disposed in the band portion.

5. The multilayer electronic component of claim 1, wherein, when a maximum size in the second direction of the multilayer electronic component measured at the central portion is defined as Lm1, and a maximum size in the second direction of the multilayer electronic component measured at the outer portion is defined as Lm2, 0.01≤(Lm2-Lm1)/Lm1≤0.05 is satisfied.

6. The multilayer electronic component of claim 2, wherein, when a maximum size in the first direction of the multilayer electronic component is defined as Tm and a size in the first direction of the central portion is defined as Tc, a ratio of Tc to Tm (Tc/Tm) is 0.5 or more.

7. The multilayer electronic component of claim 1, wherein the lower electrode layer has a maximum thickness in the central portion and a minimum thickness in the outer portion.

8. The multilayer electronic component of claim 1,
wherein the upper electrode layer includes a first electrode layer disposed on one end in the first direction of the third and fourth surfaces, and a second electrode layer disposed on the other end in the first direction of the third and fourth surfaces, and
wherein the first and second electrode layers are spaced apart from each other and extend in the third direction.

9. The multilayer electronic component of claim 1, wherein the upper electrode layer includes first to fourth corner electrode layers disposed on corners of the third and fourth surfaces and spaced apart from each other.

10. The multilayer electronic component of claim 9, wherein, when a maximum size in the third direction of the multilayer electronic component is defined as Wm, a minimum distance in the third direction between the first corner electrode layer and the second corner electrode layer or a minimum distance in the third direction between the third corner electrode layer and the fourth corner electrode layer is defined as We, a ratio of We to Wm (We/Wm) is 0.8 or lower.

11. The multilayer electronic component of claim 1, wherein the upper electrode layer is disposed to surround the central portion.

12. The multilayer electronic component of claim 1, wherein the upper electrode layer includes a metal and glass.

13. The multilayer electronic component of claim 1, wherein the upper electrode layer includes a metal and resin.

14. The multilayer electronic component of claim 1, wherein at least a portion of the outer portion convexly protrudes more outwardly than the central portion.

15. The multilayer electronic component of claim 1, wherein the central portion is convex outwardly.
